(19) Europäisches Patentamt / European Patent Office / Office européen des brevets

(11) **EP 3 582 418 A1**

(12) **EUROPEAN PATENT APPLICATION**

(43) Date of publication:
**18.12.2019 Bulletin 2019/51**

(51) Int Cl.:
**H04L 1/00** *(2006.01)*   **H03M 13/27** *(2006.01)*
**H04L 5/00** *(2006.01)*

(21) Application number: **18177773.1**

(22) Date of filing: **14.06.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Nokia Solutions and Networks Oy**
**02610 Espoo (FI)**

(72) Inventors:
• LEFEVRE, Yannick
  2018 Antwerp (BE)
• COOMANS, Werner
  2018 Antwerp (BE)
• MAES, Jochen
  2018 Antwerpen (BE)

(74) Representative: **Nokia EPO representatives**
**Nokia Technologies Oy**
**Karakaari 7**
**02610 Espoo (FI)**

(54) **DTU ENCODING AND DECODING FOR FULL-DUPLEX COMMUNICATIONS**

(57)    A method is proposed for encoding DTUs (30) in a transmitter (111; 211) for further transmission to a receiver (212; 112). Communications from the transmitter to the receiver alternate between first time sub-frames (22; 24) comprising data symbols of a first type (D2; U2) having a first data payload capacity ($N_{DSC,MIN}$), and second time sub-frames (21; 23) comprising data symbols of a second type (D1; U1) having a second data payload capacity ($N_{DSC,MAX}$) greater than the first data payload capacity. The method comprises encoding individual DTUs into Q block-interleaved codewords (40) for protection against communication errors, Q denoting a positive integer value; obtaining scheduling information (txsch_info) as to the types of data symbols over which the encoded DTUs (50) are to be conveyed; and enabling or disabling the further block-interleaving of a group of M consecutive encoded DTUs (60) based on the scheduling information for the respective M consecutive encoded DTUs, M denoting a positive integer value greater than one.

The present invention also relates to a transmitter (111; 211) for encoding DTUs according to the method, and to a receiver (112; 212) for decoding the so-encoded DTUs.

Fig. 6A

EP 3 582 418 A1

**Description**

**Technical Field of the Invention**

The present invention relates to a method for encoding Data Transfer Units (DTUs), to a transmitter for encoding DTUs according to the method, and to a receiver for decoding the so-encoded DTUs.

**Technical Background of the Invention**

The International Telecommunication Union (ITU) has started working on a new recommendation called G.mgfast (Multi Gbps fast access to subscriber terminals). This recommendation will support both Time Division Duplexing (TDD) and Full-DupleX (FDX) modes. It has been agreed that FDX mode will use a framing structure consisting of two FDX time sub-frames, a FDX Downstream Sub-frame (FDS) and a FDX Upstream Sub-frame (FUS). Both sub-frames will operate in FDX mode, meaning that as well downstream (DS) as upstream (US) symbols are transmitted and received during each of these two sub-frames. The difference between FDS and FUS sub-frames is that the DS data rate is prioritized in FDS, whereas the US data rate is prioritized in FUS. As a result, the DS data rates will generally be higher in FDS than in FUS, whereas the US data rate will be higher in FUS than in FDS.

The DTUs are the basic units for data acknowledgment and data re-transmission. The DTUs are individually encoded into multiple interleaved Reed Solomon (RS) codewords for error correction, wherein the number of RS codewords into which a DTU is encoded determines the interleaving depth. The more RS codewords are interleaved, the better the performance of the error correction. However, increasing the interleaving depth may increase the traffic latency. Therefore, the number of bytes in a DTU is preferably matched to the Data Symbol Capacity (DSC) $N_{DSC}$, which in a DSL context is the number of bytes that can be modulated over one Discrete Multi-Tone (DMT) symbol. In this way the latency is minimized. To allow some flexibility, the DTU size $N_{DTU}$ is constrained in G.fast to be between 1/4 and 4 times the DSC $N_{DSC}$, that is to say:

$$1/4*N_{DSC} \leq N_{DTU} \leq 4*N_{DSC} \quad (1).$$

Because of FDX operation, the DSC in G.mgfast will generally be different for the FDS and FUS sub-frames. The largest symbol capacity (corresponding for DS to the symbol capacity of the FDS symbols, and for US to the symbol capacity of the FUS symbols) is denoted as $N_{DSC,MAX}$, while the smallest symbol capacity (corresponding for DS to the symbol capacity of the FUS symbols, and for US to the symbol capacity of the FDS symbols) is denoted as $N_{DSC,MIN}$. There can be a large difference between the two capacity values $N_{DSC,MAX}$ and $N_{DSC,MIN}$. The DTU length should then satisfy the constraint of Eq. (1) for both $N_{DSC,MAX}$ and $N_{DSC,MIN}$. This is generally not possible, for instance if $16*N_{DSC,MIN} < N_{DSC,MAX}$.

A first prior-art solution would be to use two DTU sizes: one DTU size $N_{DTU,MAX}$ during the priority sub-frames, and another DTU size $N_{DTU,MIN}$ during the non-priority sub-frames. This implies that the system would work with two types of DTUs, ones that are (re-)transmitted during the priority sub-frames, and ones that are (re-)transmitted during the non-priority sub-frames. This follows from the fact that DTUs are not reassembled before re-transmission, but are simply stored in their assembled form in the re-transmit buffer. As a consequence, re-transmission will incur additional latency compared with what is inherently possible with FDX, as one always has to wait for the next available sub-frame of the same type to re-transmit DTUs. In short, this solution would lead to the same latency as for G.fast, and would prevent from realizing the reduced FDX latency that was one of the incentives to introduce FDX paradigm for copper access.

**Summary of the Invention**

It is an object of the present invention to overcome or alleviate the aforementioned shortcomings and drawbacks.

In accordance with a first aspect of the invention, a method is proposed for encoding DTUs in a transmitter for further transmission to a receiver. Communications from the transmitter to the receiver alternate between first time sub-frames comprising data symbols of a first type having a first data payload capacity, and second time sub-frames comprising data symbols of a second type having a second data payload capacity greater than the first data payload capacity. The method comprising encoding individual DTUs into Q block-interleaved codewords for protection against communication errors, Q denoting a positive integer value. The method further comprises obtaining scheduling information as to the types of data symbols over which the encoded DTUs are to be conveyed; and enabling or disabling the further block-interleaving of a group of M consecutive encoded DTUs based on the scheduling information for the respective M consecutive encoded DTUs, M denoting a positive integer value greater than one.

The first and second data payload capacities herein refer to the capacity of a data symbol that is available for conveying the encoded DTUs. The data payload capacity may or may not match the DSC of the data symbol depending on whether other types of traffic, such as control traffic, are conveyed as well over the data symbol.

In one embodiment of the invention, the method further comprises block-interleaving the group of M consecutive encoded DTUs and transmitting the block-interleaved group of M consecutive encoded DTUs to the receiver if the M consecutive encoded DTUs are to be conveyed in whole over one or more contiguous data symbols of the second type.

In one embodiment of the invention, the method further comprises individually transmitting one or more consecutive encoded DTUs from the group of M consecutive encoded DTUs to the receiver without any further interleaving if the M consecutive encoded DTUs are to be conveyed in part over one or more data symbols of the second type and in part over one or more data symbols of the first type, or if the M consecutive encoded DTUs are to be conveyed in whole over one or more data symbols of the first type.

In an alternative embodiment of the invention, the method further comprises block-interleaving the group of M consecutive encoded DTUs and transmitting the block-interleaved group of M consecutive encoded DTUs to the receiver if the M consecutive encoded DTUs are to be conveyed in part over one or more data symbols of the second type and in part over at most a given number of data symbols of the first type, the one or more data symbols of the second type and the at most given number of data symbols of the first type being contiguous data symbols.

In one embodiment of the invention, the method further comprises individually transmitting one or more consecutive encoded DTUs from the group of M consecutive encoded DTUs to the receiver without any further interleaving if the M consecutive encoded DTUs are to be conveyed in part over one or more data symbols of the second type and in part over more than the given number of data symbols of the first type, or if the M consecutive encoded DTUs are to be conveyed in whole over one or more data symbols of the first type.

The given number of data symbols of the first type may be determined based on latency requirements, or may be assigned some pre-determined value, typically one.

In one embodiment of the invention, the first or second time sub-frames further comprise data symbols of a third type conveying control traffic from the transmitter to the receiver and having a third reduced data payload capacity. For enabling or disabling the further block-interleaving of the group of M consecutive encoded DTUs, data symbols of the third type are regarded as data symbols of the first or second type, for instance based on the time sub-frame to which they belong, or based on a comparison between the third data payload capacity and the first or second data payload capacity.

In one embodiment of the invention, the DTUs are individually encoded into Q block-interleaved codewords according to a first error code if the encoded DTUs are to be individually transmitted to the receiver without any further interleaving, and according to a second error code if the encoded DTUs are to form part of a block-interleaved group of M consecutive encoded DTUs, the error encoding being controlled based on the scheduling information for the respective encoded DTUs.

In one embodiment of the invention, a size $N_{DTU}$ of the encoded DTUs is equal to $Q.N_{FEC}$, $N_{FEC}$ denoting the codeword length, the integers Q and M being determined so as to satisfy the following two inequalities:

$$\alpha_1 \cdot N_{DPC,MIN} \leq N_{DTU} \leq \alpha_2 \cdot N_{DPC,MIN}$$

and

$$\alpha_1 \cdot \frac{N_{DPC,MAX}}{M} \leq N_{DTU} \leq \alpha_2 \cdot \frac{N_{DPC,MAX}}{M} \quad,$$

$N_{DPC,MIN}$ and $N_{DPC,MAX}$ denoting the first and second data payload capacities respectively, $\alpha_1$ and $\alpha_2$ denoting a lower-bound proportion and an upper-bound proportion of the data payload capacities.

In one embodiment of the invention, the DTUs are the basic units for data re-transmission, and individually comprise a header part, a payload part, and an error check part.

In one embodiment of the invention, communications between the transmitter and the receiver are full-duplex communications. In downstream direction, the first time sub-frames correspond to upstream-priority sub-frames and the second time sub-frames correspond to downstream-priority sub-frames. In upstream direction, the first time sub-frames correspond to downstream-priority sub-frames and the second time sub-frames correspond to upstream-priority sub-frames.

In accordance with another aspect of the invention, a transmitter comprises an encoder configured to encode DTUs, and an analog front-end configured to transmit a communication signal to a receiver, the communication signal being generated based on the encoding. Communications from the transmitter to the receiver alternate between first time sub-frames comprising data symbols of a first type having a first data payload capacity, and second time sub-frames comprising data symbols of a second type having a second data payload capacity greater than the first data payload capacity. The encoder is further configured to encode individual DTUs into Q block-interleaved codewords for protection against communication errors, Q denoting a positive integer value. The encoder is further configured to obtain scheduling information as to the types of data symbols over which the encoded DTUs are to be conveyed; and to enable or disable the further block-interleaving of a group of M consecutive encoded DTUs based on the scheduling information for the respective M consecutive encoded DTUs, M denoting a positive integer value greater than one.

In one embodiment of the invention, the encoder comprises a block-interleaver configured to block-interleave the Q codewords and the group of M consecutive encoded DTUs. The block-interleaver has an adjustable interleaving depth value adjusted to Q*M if the further block-interleaving of the group of M consecutive encoded DTUs is enabled, else to Q.

In one embodiment of the invention, the transmitter further comprises at least one processor and at least one memory including computer program code, the at least one memory and the computer program code configured to, with the at least one processor, cause the transmitter to perform the encoding.

In accordance with still another aspect of the invention, a receiver comprises an analog front-end configured to receive a communication signal from a transmitter, and a decoder configured to decode encoded DTUs from the communication signal. Communications from the transmitter to the receiver alternating between first time sub-frames comprising data symbols of a first type having a first data payload capacity, and second time sub-frames comprising data symbols of a second type having a second data payload capacity greater than the first data payload capacity. The encoded DTUs individually comprise Q block-interleaved codewords for protection against communication errors, Q denoting a positive integer value. The decoder is further configured to obtain scheduling information as to the types of data symbols over which the encoded DTUs have been conveyed; and to enable or disable the block-deinterleaving of a block-interleaved group of M consecutive encoded DTUs based on the scheduling information for the respective M consecutive encoded DTUs, M denoting a positive integer value greater than one.

In one embodiment of the invention, the decoder comprises a block-deinterleaver configured to block-deinterleave the Q block-interleaved codewords and the block-interleaved group of M consecutive encoded DTUs. The block-deinterleaver has an adjustable deinterleaving depth value adjusted to Q*M if the block-deinterleaving of the block-interleaved group of M consecutive encoded DTUs is enabled, else to Q.

In one embodiment of the invention, the scheduling information are obtained from the transmitter.

Alternatively, the scheduling information are generated locally by the receiver.

In one embodiment of the invention, the receiver further comprises at least one processor and at least one memory including computer program code, the at least one memory and the computer program code configured to, with the at least one processor, cause the receiver to perform the decoding.

Such a transmitter or receiver may form part of an access node for providing broadband access to subscribers, such as a Distribution Point Unit (DPU) or a Digital Subscriber Line Access Multiplexer (DSLAM), or may form part of a Customer Premises Equipment (CPE), such as a modem, a gateway, a router, a user terminal, etc.

Embodiments of a method according to the invention correspond with corresponding embodiments of a transmitter and/or a receiver according to the invention.

The idea of the invention is to use one type of DTU. The size of these DTUs is matched to the small DSC of the non-priority sub-frames, and are transmitted as such during the non-priority sub-frames. During the priority sub-frames with a larger DSC, several DTUs are interleaved to obtain a DTU-group, the size of which is better matched to the larger DSC of the priority sub-frames. In this way, only one type of DTU is stored in the re-transmission buffer, while the interleaving depth can be optimized per sub-frame to further improve communication reliability.

## Detailed Description of the Invention

Various example embodiments will now be described more fully with reference to the accompanying drawings wherein:

- fig. 1 represents a part of a broadband access network;
- fig. 2A represents further details of an access node and connected Customer Premises Equipment (CPEs);
- fig. 2B represents further details of a transceiver;
- fig. 3 represents a time frame structure for FDX communications;
- fig. 4A represents the structure of a DTU before encoding;
- fig. 4B represents the block-interleaving of Q codewords;
- fig. 4C represents the structure of an encoded DTU;

- fig. 5A represents the block-interleaving of a group of M encoded DTUs;
- fig. 5B represents the structure of a DTU-group.
- fig. 6A represents a mapping of DTUs and DTU-groups onto data symbols;
- fig. 6B represents an alternative mapping of DTUs and DTU-groups onto data symbols;
- fig. 7 represents a first encoder architecture;
- fig. 8 represents a second encoder architecture;
- fig. 9 represents a decoder architecture; and
- fig. 10 represents the possible encoder and decoder configurations with respect to the minimum and maximum DSCs.

Accordingly, while example embodiments are capable of various modifications and alternative forms, embodiments thereof are shown by way of example in the drawings and will herein be described in detail. It should be understood, however, that there is no intent to limit example embodiments to the particular forms disclosed, but on the contrary, example embodiments are to cover all modifications, equivalents, and alternatives falling within the scope of the claims. Like numbers refer to like elements throughout the description of the figures.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of example embodiments. As used herein, the term "and/or" includes any and all combinations of one or more of the associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

Portions of example embodiments and corresponding detailed description are presented in terms of software, or algorithms and symbolic representations of operation on data bits within a computer memory. These descriptions and representations are the ones by which those of ordinary skill in the art effectively convey the substance of their work to others of ordinary skill in the art. An algorithm, as the term is used here, and as it is used generally, is conceived to be a self-consistent sequence of steps leading to a desired result. The steps are those requiring physical manipulations of physical quantities. Usually, though not necessarily, these quantities take the form of optical, electrical, or magnetic signals capable of being stored, transferred, combined, compared, and otherwise manipulated. It has proven convenient at times, principally for reasons of common usage, to refer to these signals as bits, values, elements, symbols, characters, terms, numbers, or the like.

In the following description, illustrative embodiments will be described with reference to acts and symbolic representations of operations (e.g., in the form of flowcharts) that may be implemented as program modules or functional processes including routines, programs, objects, components, data structures, etc., that perform particular tasks or implement particular abstract data types and may be implemented using existing hardware at existing network elements or control nodes. Such existing hardware may include one or more Central Processing Units (CPU), Digital Signal Processors (DSP), Application Specific Integrated Circuits (ASIC), Field Programmable Gate Arrays (FPGA), System-on-Chip (SoC), microcontroller, or the like.

Unless specifically stated otherwise, or as is apparent from the discussion, terms such as "processing" or "computing" or "calculating" or "determining" or "displaying" or the like, refer to the action and processes of a computer system, or similar electronic computing device, that manipulates and transforms data represented as physical, electronic quantities within the computer system's registers and memories into other data similarly represented as physical quantities within the computer system memories or registers or other such information storage, transmission or display devices.

Note also that the software implemented aspects of example embodiments are typically encoded on some form of tangible (or recording) storage medium. The tangible storage medium may be magnetic (e.g., a floppy disk or a hard drive), optical (e.g., a compact disk read only memory, or "CD ROM"), and may be read-only memory (ROM), random access memory (RAM), flash memory (e.g., USB flash drives, memory cards, memory sticks, etc.), for example. The terms "tangible storage medium" and "memory" may be used interchangeably. Example embodiments are not limited by these aspects of any given implementation.

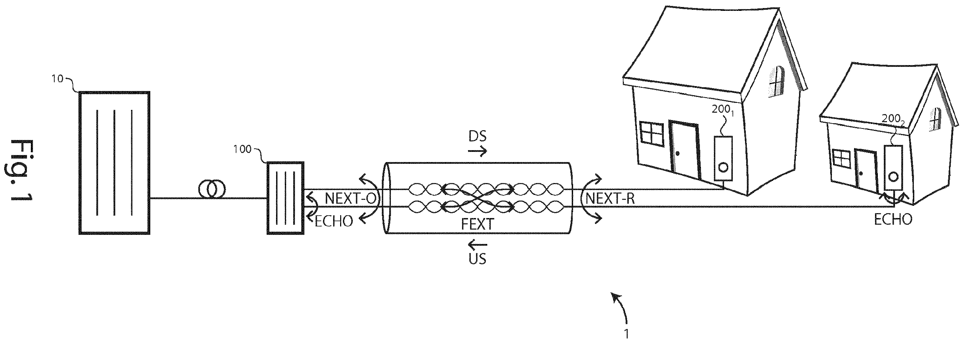

There is seen in fig. 1 a broadband access network 1 for providing Internet broadband access to subscribers.

The broadband access network 1 comprises a network unit 10 for traffic aggregation and routing through an operator's network. The network unit 10 backhauls a DPU 100 via one or more optical fibers. Such a deployment is also known as Fiber To The Node (FTTN) or alike.

The DPU 100 is further coupled through a copper plant to respective CPEs 200 at various subscriber premises. The copper plant comprises individual copper pairs connecting the DPU 100 to respective CPEs 200. The copper pairs share a common binder, wherein the subscriber lines are in close vicinity and thus induce crosstalk into each other (see 'FEXT' in fig. 1), and then run though dedicated segments for final connection to the CPEs 200. The copper pairs are typically Unshielded Twisted Pairs (UTP).

The DPU 100 and the CPEs 200 establish and operate bidirectional communication channels for conveying user and control traffic to/from the subscribers over the respective copper pairs. Downstream (DS) direction refers to the direction from the DPU 100 to the CPEs 200, and upstream (US) direction refers to the direction from the CPEs 200 to the DPU 100.

The DPU 100 operates the copper pairs according to FDX G.mgfast communication standard (work still in progress), wherein carriers are simultaneously used in both DS and US directions. Various impairments affects FDX communications.

Far-End Crosstalk (FEXT) refers to mutual Electro-Magnetic (EM) coupling of communication signals traveling in the same directions of communication over neighboring pairs. DS FEXT refers to a DS communication signal transmitted by the DPU 100 to a CPE 200 coupling into and impairing another DS communication signal transmitted by the DPU 100 to another CPE 200. US FEXT refers to an US communication signal transmitted by a CPE 200 to the DPU 100 coupling into and impairing another US communication signal transmitted by another CPE 200 to the DPU 100.

Near-End Crosstalk (NEXT) refers to mutual EM coupling of communication signals traveling in opposite directions of communication. NEXT-O ('O' stands for the operator side) refers to a DS communication signal transmitted by the DPU 100 to a CPE 200 coupling back into and impairing an US communication signal received by the DPU 100 from another CPE 200. NEXT-R ('R' stands for the remote subscriber side) refers an US communication signal transmitted by a CPE 200 to the DPU 100 coupling back into and impairing a DS communication signal received by another CPE from the DPU 100.

Echo refers to the transmit signal of a transceiver coupling into its own receive path.

Echo can be mitigated by the use of a hybrid circuit for coupling the transmitter output to the line and the line to the receiver input while isolating (up to a certain extent) the transmitter output from the receiver input. Some additional echo cancellation circuitry can then eliminate the residual echo left by the hybrid at the receiver input.

FEXT and NEXT-O can be mitigated at the DPU 100 by means of appropriate signal coordination (aka signal vectoring).

No signal coordination is possible for mitigating NEXT-R. Consequently, FDX sub-frames have been split into two time-sub-frames: first time sub-frames FDS during which downstream data rates are maximized by appropriate back off of the upstream transmit power (so as to lower the level of NEXT-R at the CPEs 200), resulting in lower US data rates than achievable; and second time sub-frames FUS during which the upstream data rates are maximized by letting the CPEs 200 transmit at their nominal power, yet at the expense of the DS data rates that are severely affected by NEXT-R. This FDX scheme can still achieve substantially higher DS and US data rates compared to TDD, and does not suffer from the additional latency associated with TDD systems.

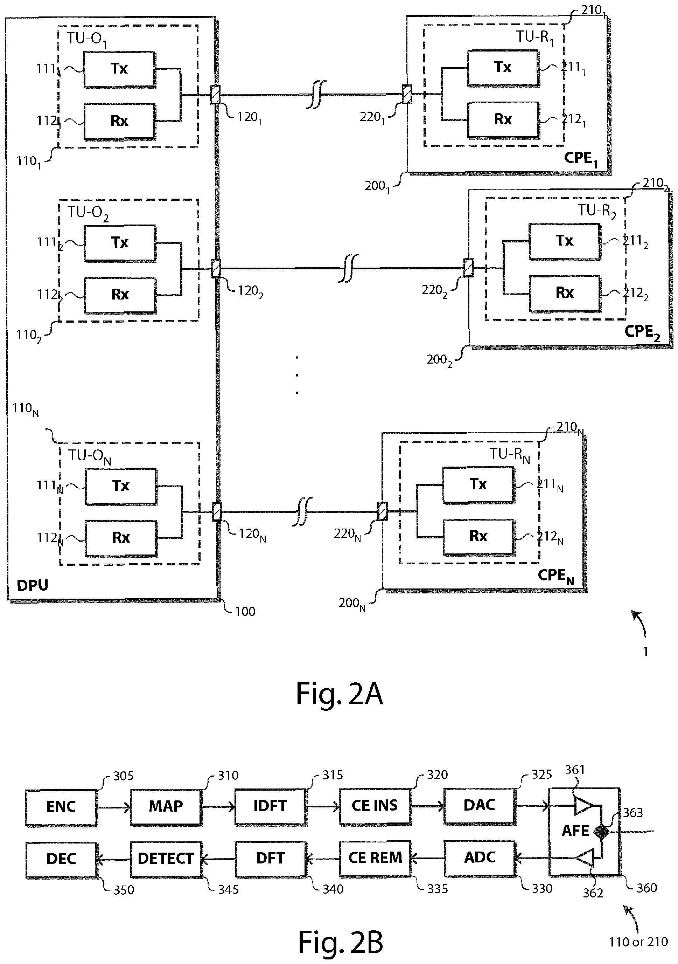

There is seen in fig. 2A further details about the DPU 100 and the CPEs 200.

The DPU 100 comprises N transceiver units 110 (TU-O1 to TU-ON) coupled to respective N line ports 120. The CPEs 200 (CPE$_1$ to CPE$_N$) individually comprises a transceiver unit 210 (TU-R1, TU-RN) coupled to a line port 220. The line ports 120 of the DPU 100 are coupled to the line ports 220 of the respective CPEs 200 through respective transmission lines.

The transceiver units 110 individually comprise a transmitter 111 (Tx) for DS communication and a receiver 112 (Rx) for US communication coupled to the line port 120. Similarly, the transceiver units 210 individually comprise a transmitter 211 (Tx) for US communication and a receiver 212 (Rx) for DS communication coupled to the line port 220.

The DPU 100 further comprises a vectoring processor (not shown) for mitigating DS/US FEXT and NEXT-O, and some echo cancellation circuitry for mitigating the echo.

The CPEs 200 similarly comprise some echo cancellation circuitry for mitigating the echo.

There is seen in fig. 2B further details about the transceiver units 110 or 210.

The transceiver units 110 or 210 individually comprise an encoder 305 (ENC) for encoding user and control traffic for further modulation, a mapper 310 (MAP) for parsing and mapping the encoded bit stream to respective I/Q constellation points of respective carriers, an Inverse Discrete Fourier Transform module 315 (IDFT) for synthesizing a discrete time sequence from the frequency representation of the transmit signal, e.g. by means of the Inverse Fast Fourier Transform (IFFT) algorithm, a module 320 (CE INS) for inserting a Cyclic Extension (CE), a Digital to Analog Converter 325 (DAC) for converting the digital transmit signal into the analog domain, and an Analog Front-End 360 (AFE).

The analog front-end 360 comprises a line driver 361 for amplifying the transmit signal and driving the transmission line with enough power, a Low Noise Amplifier 362 (LNA) for amplifying the signal received from the transmission line with as little noise as possible, and a hybrid 363 for coupling the transmitter output to the transmission line and the transmission line to the receiver input while achieving high isolation between the transmit and receive paths. The analog front-end 360 may further comprise transmit-filter and/or receive-filter circuitries, impedance-matching circuitry, and isolation circuitry.

The transceiver units 110 or 210 further individually comprise an Analog to Digital Converter 330 (ADC) for sampling the receive analog signal, a module 335 (CE REM) for removing the CE, a Discrete Fourier Transform module 340 (DFT) for generating a digital frequency representation of the receive digital samples, e.g. by means of the Fast Fourier Transform (FFT) algorithm, a hard or soft detector 345 (DETECT) for determining the original binary sequences that have been modulated over the respective carriers, and a decoder 350 (DEC) for decoding user and control traffic from the demodulated bits.

The encoder 305, the mapper 310, the IDFT module 315, the CE insertion module 320, the CE removal module 335, the DFT module 340, the detector 345 and the decoder 350 are typically implemented by means of at least one processor and at least one memory including computer program code, the at least one memory and the computer program code configured to, with the at least one processor, cause the transmitter and the receiver to perform the aforementioned steps.

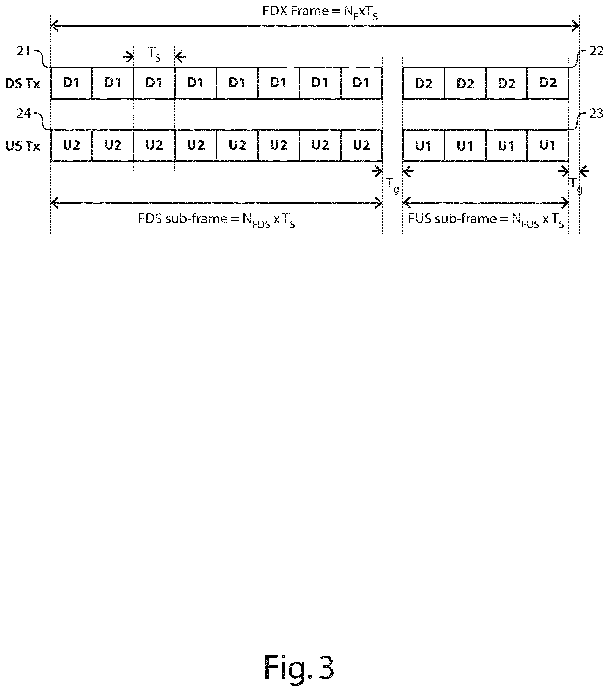

There is seen in fig. 3 the time frame structure for FDX communications between the DPU 100 and the respective CPEs 200.

The communication signals transmitted by the DPU 100 and the CPEs 200 shall conform to the frame structure depicted in fig. 3A. One FDX frame comprises $N_F$ DMT symbol positions. The duration of one DMT symbol is denoted as Ts, and the frame structure repeats itself after a period equal to $N_F*T_S$.

The FDX frame is further sub-divided into a first time sub-frame FDS comprising $N_{FDS}$ DMT symbol positions and during which DS communications are prioritized, and a second time sub-frame FUS comprising $N_{FUS}$ DMT symbol positions and during which US communications are prioritized.

In the DS direction, during the FDS sub-frames, the DPU 100 transmits a sequence of $N_{FDS}$ DMT symbols of a type D1 having a high DS data payload capacity $N^{(DS)}_{DSC,MAX}$ (see sub-frame 21 in fig. 3); and during the FUS sub-frames, the DPU 100 transmits a sequence of $N_{FUS}$ DMT symbols of a type D2 having a low DS data payload capacity $N^{(DS)}_{DSC,MIN}$ (see sub-frame 22 in fig. 3) .

Similarly, in the US direction, during the FUS sub-frames, a CPE 200 transmits a sequence of $N_{FUS}$ DMT symbols of a type U1 having a high US data payload capacity $N^{(US)}_{DSC,MAX}$ (see sub-frame 23 in fig. 3); and during the FDS sub-frames, the CPE 200 transmits a sequence of $N_{FDS}$ DMT symbols of a type U2 having a low US data payload capacity $N^{(US)}_{DSC,MIN}$ (see sub-frames 24 in fig. 3).

Presently, the data symbols D1, D2, U1 and U2 are assumed to convey DTU traffic only, implying that their data payload capacity matches the DSCs of the respective data symbols.

As depicted in fig. 3, some time gaps Tg may be provisioned between the end of one sub-frame and the beginning of the next sub-frame so as to allow the transceivers to switch between the FDS and FUS contexts. But other FDX frame structure are possible as well, such as the so-called 'zero-gap' mode wherein there are no time gaps between successive sub-frames, or equivalently wherein Tg = 0.

The DPU 100, resp. the CPEs 200, does not necessarily use all symbol positions, and may insert IDLE or QUIET symbols on a line instead of the data symbols D1 or D2, resp. U1 or U2, e.g. if there is no traffic to be sent over the line. These IDLE or QUIET symbols shall be properly accounted for to derive appropriate scheduling information.

The FDS sub-frames and/or the FUS sub-frames may further include data symbols of a third type for conveying control traffic, such as RMC symbols. These symbols may be partly used for conveying the encoded DTUs, yet with a reduced data payload capacity with respect to the regular data symbols. Again, the corresponding symbol positions and their reduced data payload capacity shall be properly accounted for to derive appropriate scheduling information.

Also, the FDS sub-frame or the FUS sub-frame may further include data symbols of a fourth type that do not convey any data payload, such as SYNC symbols that are used for crosstalk estimation, or PILOT symbols. Again, the corresponding symbol position shall be properly accounted for to derive appropriate scheduling information.

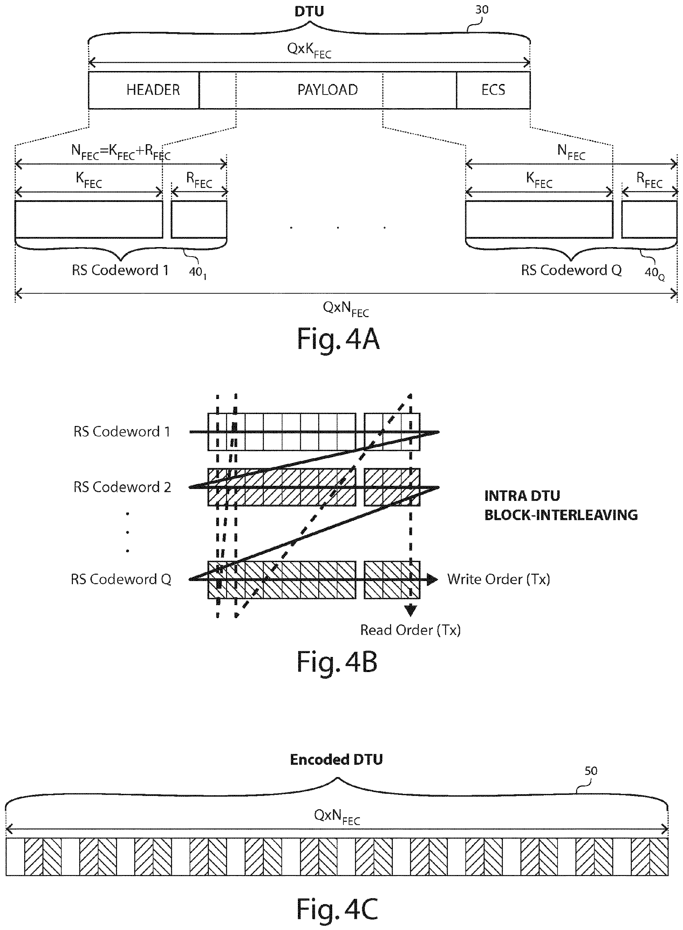

There is seen in fig. 4A the content of a DTU 30. A DTU is the basic unit for data acknowledgment and re-transmission between a transmitter and a receiver. The DTU 30 comprises a header part (HEADER), a data payload part (PAYLOAD) and an Error Check Sequence part (ECS), such as a CRC code.

The header part includes a sequence identifier that uniquely identifies a particular DTU, and that is used at the receive side for DTU re-ordering and DTU acknowledgment. The ECS allows the receiver to check the data integrity of the received DTUs, and to ask for their re-transmission if their ECS is incorrect.

The DTU 30 is chopped into Q blocks of $K_{FEC}$ consecutive bytes. A systematic Reed Solomon (RS) code converts the information sequences of $K_{FEC}$ bytes into codewords 40 of $N_{FEC}$ bytes by appending $R_{FEC} = N_{FEC} - K_{FEC}$ parity bytes. After RS encoding, one DTU spans $Q*N_{FEC}$ bytes.

There is seen in fig. 4B the block-interleaving of the Q RS codewords composing one DTU. The bytes of the Q RS codewords (represented as rectangles in fig. 4B) are written in an interleaving memory according to a certain order, presently horizontally from left to right (see 'Write Order (Tx)' in fig. 4B), and then read according to another order, presently from top to bottom (see 'Read Order (Tx)' in fig. 4B).

As shown in fig. 4C, this results in an encoded DTU 50 comprising Q*NFEC bytes (i.e., the Q block-interleaved RS codewords), wherein each byte of a given RS codeword is separated from another byte of the same RS codeword by Q bytes, Q being then the interleaving depth. This first interleaving step is referred to as 'intra-DTU interleaving'.

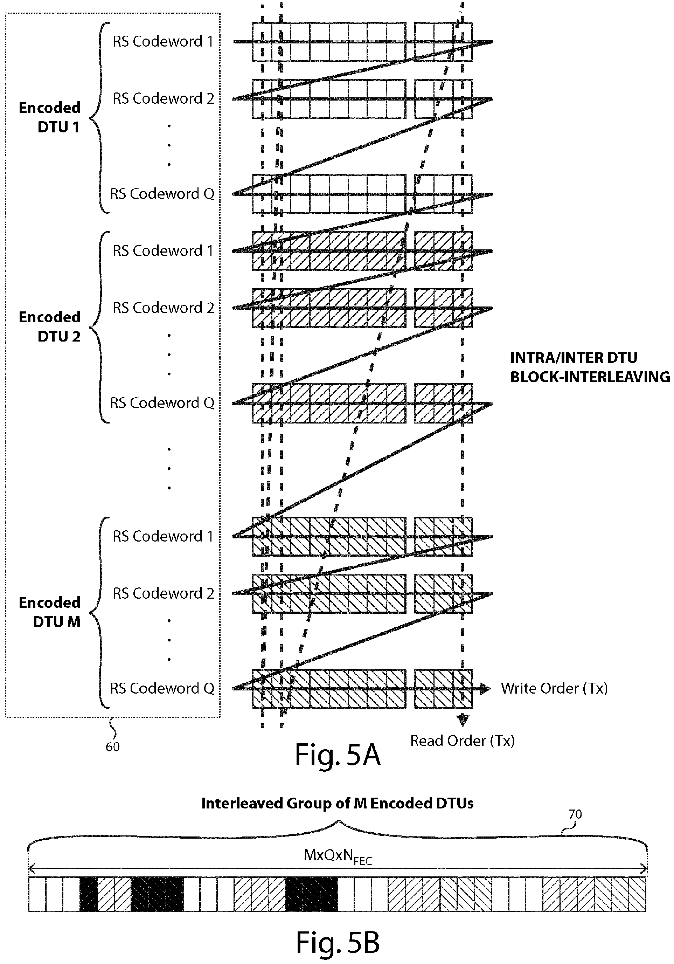

There is seen in fig. 5A a grouping of M consecutive encoded DTUs 60 into one DTU-group. A further block-interleaving may be applied to the M encoded DTUs in addition to the intra-DTU interleaving depending on the type of sub-frame during which the M encoded DTUs are to be conveyed. This further optional interleaving step is referred to as 'inter-DTU interleaving'.

The interleaving can be applied per bytes (one switches every byte between the M encoded DTUs), or per Q bytes (one switches every Q bytes between the M encoded DTUs). As depicted in fig. 5A, the latter allows to merge the first block-interleaving of the RS codewords and the further block-interleaving of M encoded DTUs into one single block-interleaving with an interleaving depth equal to M*Q.

As shown in fig. 5B, this results in a block-interleaved group of M encoded DTUs 70 comprising M*Q*NFEC bytes, wherein each byte of a given RS codewords is separated from another byte of the same RS codeword by M*Q bytes, thereby increasing the robustness of the RS code.

The main difference between a DTU-group and a single DTUs comprising M*Q RS codewords is that a DTU-group is not used as a basis for data re-transmission whereas the DTU is. An incorrectly received DTU, which was initially part of a DTU-group, may later on be re-transmitted individually or within a DTU-group, not necessarily with the same DTUs, depending on the type of sub-frame during which the DTU is to be re-transmitted.

A further difference is that there are M DTU headers and ECSs included in the DTU-group, and thus more overhead compared to a single DTU with M*Q RS codewords. Note that, in the worst-case, this would increase overhead from 0.2% (=7/(16*255)) to 2.75% if 16 DTUs of 1 RS codeword are interleaved. The overhead penalty due to the multiple ECSs could be mitigated by using shorter ECSs as the DTUs have a smaller size matched to $N_{DSC,MIN}$.

The parameters $N_{FEC}$, $R_{FEC}$, Q and M are determined so as to satisfy the following two inequalities:

$$\alpha_1 \cdot N_{DSC,MIN} \leq N_{DTU} \leq \alpha_2 \cdot N_{DSC,MIN} \qquad (2),$$

$$\alpha_1 \cdot \frac{N_{DSC,MAX}}{M} \leq N_{DTU} \leq \alpha_2 \cdot \frac{N_{DSC,MAX}}{M} \qquad (3),$$

wherein $N_{DSC,MAX}$ and $N_{DSC,MIN}$ denote the high and low data payload capacities of the data symbols in a given direction of communication, and $\alpha_1$ and $\alpha_2$ denote a lower-bound proportion and a upper-bound proportion of the data payload capacities. In G.fast, $\alpha_1 = 1/4$ and $\alpha_2 = 4$, but other bounds are possible as well.

Alternatively, different bound values for $N_{DSC,MIN}$ and $N_{DSC,MAX}$ data channel capacities can be used in eq. (2) and (3) for determining the parameters $N_{FEC}$, $R_{FEC}$, Q and M, yielding:

$$\alpha_{1,MIN} \cdot N_{DSC,MIN} \leq N_{DTU} \leq \alpha_{2,MIN} \cdot N_{DSC,MIN} \qquad (4),$$

$$\alpha_{1,MAX} \cdot \frac{N_{DSC,MAX}}{M} \leq N_{DTU} \leq \alpha_{2,MAX} \cdot \frac{N_{DSC,MAX}}{M} \qquad (5).$$

In G.fast, the parameters $N_{FEC}$, $R_{FEC}$ and Q are typically chosen so that the throughput for a given channel is optimized while satisfying Eq. (1). When using DTUs and DTU-groups as presently proposed, these values may be selected according to one of the following method:

- Select the FEC settings so that the throughput is optimized for the DTU-groups, i.e. when M*Q codewords are interleaved. This corresponds to optimizing the throughput for the priority sub-frame symbols (i.e., so that the FDS throughput is optimized in DS direction, and so that the FUS throughput is optimized in US direction). For this option, the G.fast selection procedure can be reused, and simply applied to the priority sub-frame symbols. Afterwards, M can be chosen so that Eq. (2) or (4) is satisfied for the non-priority sub-frame symbols. Due to its simplicity, this is the preferred option.

- Select the FEC settings so that the average throughput for the priority and non-priority sub-frame symbols is optimized. This takes into account that typically the amount of priority/non-priority symbols in a frame is variable, and that this amount is varied based on a Dynamic Time Assignment (DTA) mechanism, such as cDTA or iDTA mechanism in G.fast. In some use-case, all DTA settings are equally probable, so that the average throughput per-symbol corresponds to the average throughput of the priority and non-priority sub-frame symbols.

- Select the FEC settings so that a weighted average of the throughput of the priority and non-priority subframe symbols is optimized. In case not all the DTA settings are equally probable, this option is for instance necessary to optimize the average throughput per-symbol. Here the weighting can be chosen based on which DTA settings are more probable. The weighting might also be based on an operator Service Level Agreement (SLA), such as the targeted US-DS data rate ratio.

The DTUs and the DTU-groups could use different FEC settings. For instance, they could use a different amount of parity bytes $R_{FEC}$ per RS codeword.

The main difference between the DTUs and the DTU-groups is the interleaving depth (Q versus Q*M). However, even for given $N_{FEC}$ and $R_{FEC}$ values, a different interleaving depth leads to different SNR requirements for the different bit-loadings. Hence, it would be advantageous to use different SNR thresholds when determining the bit-loading of the respective carriers to be used during the priority and non-priority sub-frame symbols.

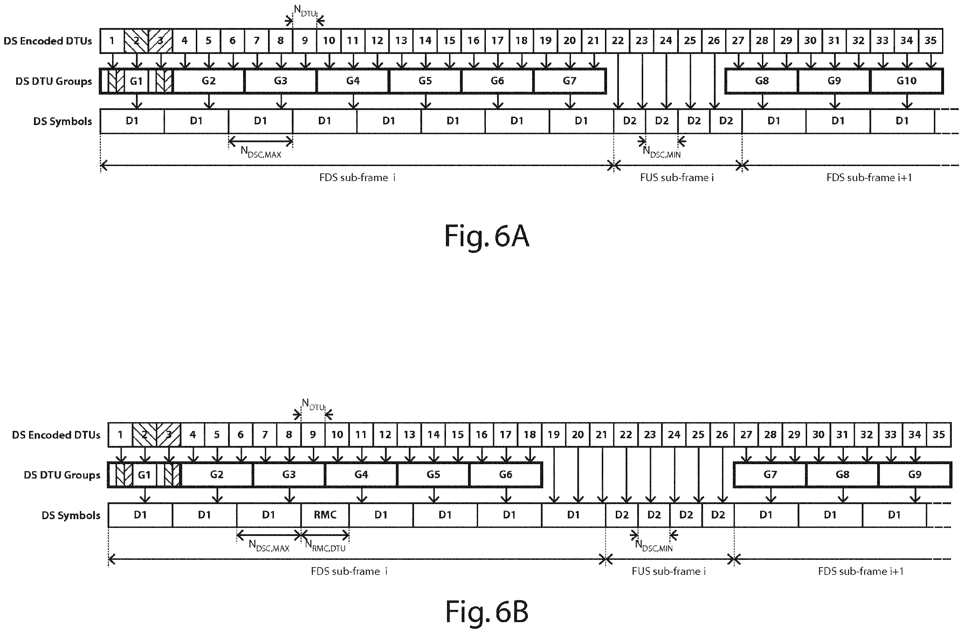

There is seen in fig. 6A an illustrative example of the mapping of the DTUs transmitted in DS direction over the DS data symbols. A similar description could be done for the US direction.

The top row represents consecutive encoded DTUs transmitted in DS direction, each comprising Q block-interleaved RS codewords. The encoded DTUs are numbered from 1 to 35. The bottom row represents the DS data symbols, presently data symbols D1 with high data payload capacity $N^{(DS)}_{DSC,MAX}$ during the FDS sub-frame, and data symbols D2 with low data payload capacity $N^{(DS)}_{DSC,MIN}$ during the FUS sub-frame. The scale over the horizontal axis is with respect to the amount of DTU bytes transmitted over the transmission line: as one can see, the data symbols D1 have a larger width than the data symbols D2 on account of their higher data payload capacity. The encoded DTUs have a fixed size $N^{(DS)}_{DTU}$ (and thus have equal width in fig. 6A), whose value is selected with respect to the low data payload capacity $N^{(DS)}_{DSC,MIN}$. Presently, the DTU size $N^{(DS)}_{DTU}$ is almost matched to $N^{(DS)}_{DSC,MIN}$, and the width of the encoded DTUs almost matches the width of the data symbols D2.

Next, it is determined over which type of data symbols the encoded DTUs 1 to 35 are to be conveyed. Presently, the encoded DTUs 1 to 21 and 28 to 35 are to be wholly conveyed over one or more data symbols of type D1 with high data payload capacity; the encoded DTUs 23 to 26 are to be wholly conveyed over one or more data symbols of type D2 with low data payload capacity; and the encoded DTUs 22 and 27 are to be partly conveyed over one data symbol of type D1 and partly conveyed over one data symbol of type D2.

Based on these scheduling information as to the types of data symbol over which the encoded DTUs are to be conveyed, one determines whether the encoded DTUs shall be further grouped into DTU-groups and further block-interleaved, or whether they shall be sent individually without any further block-interleaving.

As a first core rule, if M consecutive encoded DTUs are to be transmitted in whole during the FDS sub-frame, or alternatively if M consecutive encoded DTUs are to be conveyed in whole over one or more data symbols of type D1 with high data payload capacity, then the M consecutive encoded DTUs are grouped and block-interleaved together.

Presently, M = 3: the 3 consecutive encoded DTUs 1, 2 and 3 are grouped and block-interleaved into DTU-group G1; the next 3 consecutive encoded DTUs 4, 5 and 6 are grouped and block-interleaved into DTU-group G2; and so forth till DTU-group G7; which comprises the encoded DTUs 19, 20 and 21.

As a second additional rule, one may group and block-interleaved M consecutive encoded DTUs if the M consecutive encoded DTUs are transmitted partly during the FDS sub-frame and partly during the FUS sub-frame, provided the M consecutive encoded DTUs do not span beyond a given number L of data symbols of type D2 with low data payload capacity, or alternatively if the M consecutive encoded DTUs are to be conveyed in part over one or more data symbols of type D1, and in part over at most L (i.e., L or less) data symbols of type D2. L can be set to a given value, or can be determined based on specific latency requirements.

Presently L=1: the next 3 consecutive encoded DTUs 22, 23 and 24 span over the last data symbol D1 of the FDS sub-frame and over the first two data symbols D2 of the next FUS sub-frame. As a consequence, the encoded DTU 22 is sent individually without any further interleaving. The process repeats, and now one checks whether the 3 encoded DTUs 23, 24 and 25 to be transmitted next fulfill any of the two above rules, which is not the case again, and thus the encoded DTU 23 is sent individually without any further interleaving, and so are the next encoded DTUs 24, 25 and 26. Nevertheless, on account of the second rule, the 3 consecutive encoded DTUs 27, 28 and 29 are grouped and block-interleaved into DTU-group G8 as the DTU-group G8 spans over the last data symbol D2 of the FUS sub-frame and over the first data symbol D1 of the next FDS sub-frame. And, on account of the first rule, so are the next 3 consecutive encoded DTUs 30, 31 and 32 into DTU-group G9; and the next 3 consecutive encoded DTUs 33, 34 and 35 into DTU-group G10.

An alternative mapping is depicted in fig. 6B. The second rule above is not followed, meaning that M consecutive encoded DTUs are grouped and block-interleaved only if these M DTUs are to be conveyed in whole over one or more data symbols of type D1, else they are sent individually without any further interleaving. As a consequence, the encoded DTUs 19 to 21 are sent individually without any further interleaving as the corresponding group of 3 encoded DTUs would partly overlap with the FUS sub-frame. And so are the DTUs 22 to 26, which are to be conveyed in whole over one or more data symbols of type D2. The next 3 consecutive encoded DTUs 27, 28 and 29 are to be conveyed in whole over one or more data symbols of type D1, and thus are grouped and block-interleaved into DTU-group G7, and so forth.

The FDS sub-frame has been depicted in fig. 6B as further including one RMC symbol.

The RMC symbols have a reduced bit loading in order to improve their resilience to noise. The RMC symbols carry control data exchanged over the RMC channel, inc. the DTU acknowledgment information sent from the receiver to the transmitter through the RMC back-channel, as well as framing control parameters. The RMC symbols further carry some DTU payload, yet with a reduced data payload capacity $N_{RMC,DTU}$ for conveying the DTUs on account of the reduced bit loading and the sharing of the total RMC symbol capacity (in fig. 6B, the RMC symbol has a reduced width compared to regular data symbols D1). The presence of the RMC symbol has a clear impact on the scheduling of the next DTUs over the data symbols, and shall be properly accounted for.

The RMC DS and US symbols are at specific symbol positions of the respective priority sub-frames (i.e., FDS for DS direction, and FUS for US direction). It is not yet agreed whether the non-priority sub-frames (i.e., FUS for DS direction, and FDS for US direction) will also include a second RMC symbol in order to speed up DTU acknowledgment and improve the latency in case of DTU re-transmission.

Different rules can be followed when a DTU-group is to be conveyed in whole or in part over an RMC symbol. We may either regard the RMC symbols as data symbols of the same type than the frame they belong to, namely to consider DS RMC symbols as of type D1 if the DS RMC symbol belongs to the FDS sub-frame, and as of type D2 if the DS RMC symbol belongs to the FUS sub-frame, and similarly to consider US RMC symbols as of type U1 if the US RMC symbol belongs to the FUS sub-frame, and as of type U2 if the US RMC symbol belongs to the FDS sub-frame.

Alternatively, one may consider the DS RMC symbols as being always of type D2, and the US RMC symbols as being always of type U2.

Still alternatively, one may compare the reduced data payload capacity of the RMC symbols $N_{RMC,DTU}$ with $N_{DSC,MAX}$ and $N_{DSC,MIN}$, and regard the RMC symbols as being of type D1/U1 or D2/ U2 based on the comparison, for instance by selecting the symbol type that has the closest data payload capacity.

In fig. 6B, the RMC symbol is considered as a data symbol of type D1, and consequently, the encoded DTUs 7, 8 and 9 are grouped and block-interleaved into DTU-group G3. And so are the encoded DTUs 10, 11 and 12 into DTU-group G4.

Alternatively, the RMC symbol can be regarded as a data symbol of type D2, in which case the encoded DTUs 7 to 10 would be individually transmitted without any further interleaving.

As one can notice, the grouping scheme in fig. 6A more closely fits the FDX frame structure than the grouping scheme in fig. 6B does. This increased coding performance is not achieved at the expense of the latency. Presently in fig. 6A, with the proper choice of L=1, the DTU-groups span over two DMT symbols at most, even during the sub-frame transitions.

Symbols that do not carry any DTU payload may also be inserted within the FDX frame structure, such as IDLE or QUIET symbols when no traffic is to be sent, or SYNC symbols for crosstalk estimation. These 'empty' symbols shall be properly accounted for when deciding whether to enable the further block-interleaving of a group of M consecutive encoded DTUs as those symbols have a direct impact on the incurred latency. For instance, if a DTU-group is to be conveyed over data symbols of type D1 or U1 that are separated by empty symbol positions, then it might be preferable to send individual DTUs instead.

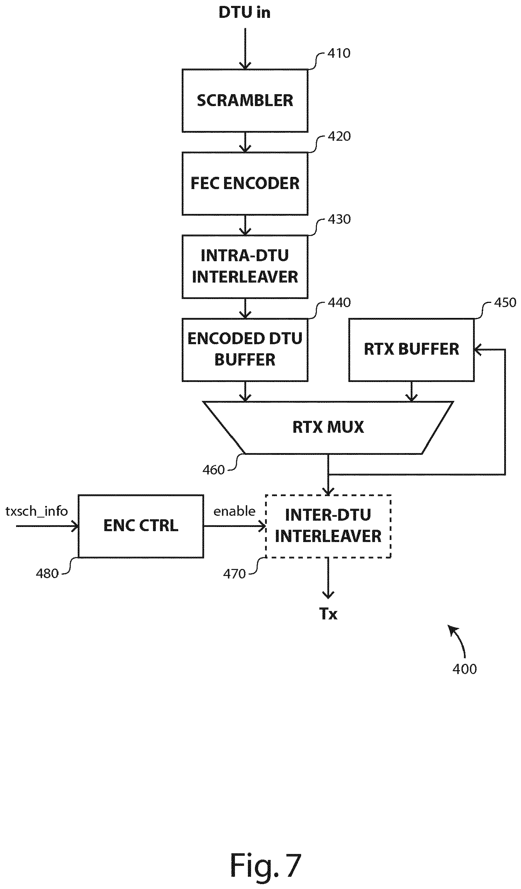

There is seen in fig. 7 a first architecture 400 for an encoder as per the invention. The DTUs go through a scrambler 410 for randomizing the DTU bytes, next through the FEC encoder 420 for generating the Q RS codewords, next through an intra-DTU block interleaver 430 for block-interleaving the Q RS codewords. The encoded DTUS are then pushed into a DTU buffer 440. A re-transmission buffer 450 (RTX BUFFER) holds the transmitted DTUs that have been transmitted so far till they are acknowledged or till some re-transmission timer expires. A multiplexer 460 (RTX MUX) selects the DTUs from the re-transmission buffer 450 first if a DTU needs to be re-transmitted (i.e., NACKed DTU), else from the DTU buffer 440 (re-transmitted DTUs have higher priority).

An encoder controller 480 (ENC CTRL) controls whether a group of M encoded DTUs successively retrieved from the buffer 440 and/or the buffer 450 shall be further block-interleaved by enabling or disabling the inter-DTU block interleaver 470 based on transmit scheduling information txsch_info.

Finally, the bytes of the encoded DTUs are sent individually or as a block-interleaved group of M successive encoded DTUs to the PMD layer for further modulation and transmission. In this architecture, the encoding of the DTUs is only performed once, and the DTUs are stored in encoded form in the re-transmission buffer 450, while the inter-DTU block-interleaving is applied on the fly depending on the actual transmission schedule.

The transmit scheduling information txsch_info comprises an indication as to the type of data symbols over which the next encoded DTUs are to be conveyed. The transmit scheduling info txsch_info are typically retrieved from the PMD layer. For instance, upon accepting $N_{DSC,MAX}$ or $N_{DSC,MIN}$ bytes from the encoder 400 for further modulation over one next DMT symbol, the PMD layer may return the respective types of the data symbols that will be used for conveying the next M or more DTUs. Alternatively, the transmit scheduling information txsch_info may be directly determined by the encoder controller 480 based on the transmission parameters that are currently used by the PMD layer.

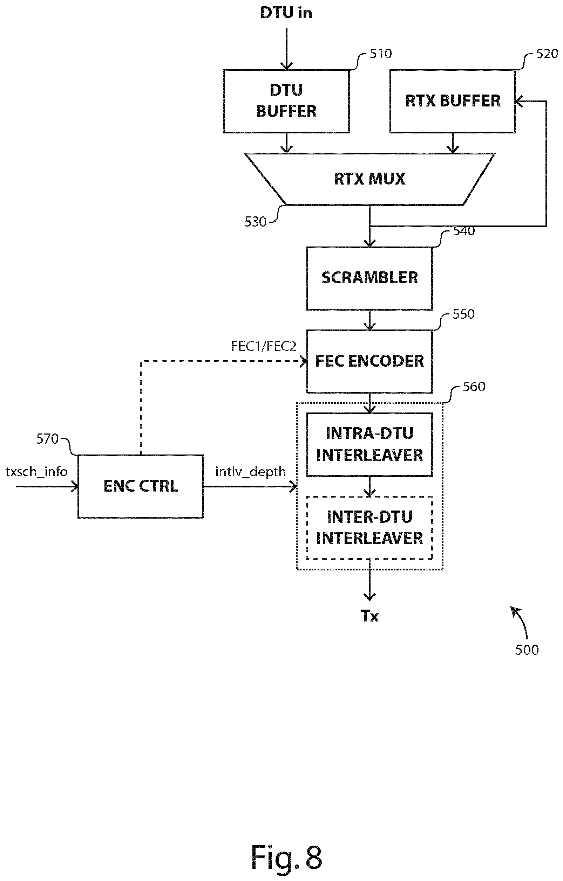

There is seen in fig. 8 an alternative architecture 500 for an encoder as per the invention. The original DTUs are stored in un-coded form within a DTU buffer 510, and within a re-transmission buffer 520 for further re-transmission if any. Again, a multiplexer 530 selects the DTUs from the re-transmission buffer 520 first if a DTU needs to be re-transmitted, else from the DTU buffer 510. The selected DTUs go through the scrambler 540, the FEC encoder 550, and next through a single block-interleaver 560 configured to perform the intra-DTU block-interleaving, possibly in conjunction with the inter-DTU block-interleaving. An encoder controller 570 controls the interleaving depth intl_depth of the block-interleaver 560 based on transmit scheduling information txsch_info. Namely, based on the transmit scheduling information txsch_info, the encoder controller 570 adjusts the interleaving depth intl_depth to Q if the encoded DTUs are to be sent individually without any further inter-DTU interleaving, or adjusts the interleaving depth intl_depth to M*Q if the encoded DTUs are to be sent in DTU-groups with the further inter-DTU interleaving enabled.

This architecture further allows the encoder controller 570 to adjust the FEC settings on the fly to FEC1 or FEC2 based on whether inter-DTU interleaving is applied or not. In this way, one can tailor the FEC settings so as to optimize the data rates for the respective sub-frames. FEC1 and FEC2 settings do not necessarily share the same error code or the same information length $K_{FEC}$.

In this embodiment, more processing power is required in case of re-transmission as the DTU are stored in un-coded form in the re-transmission buffer 520.

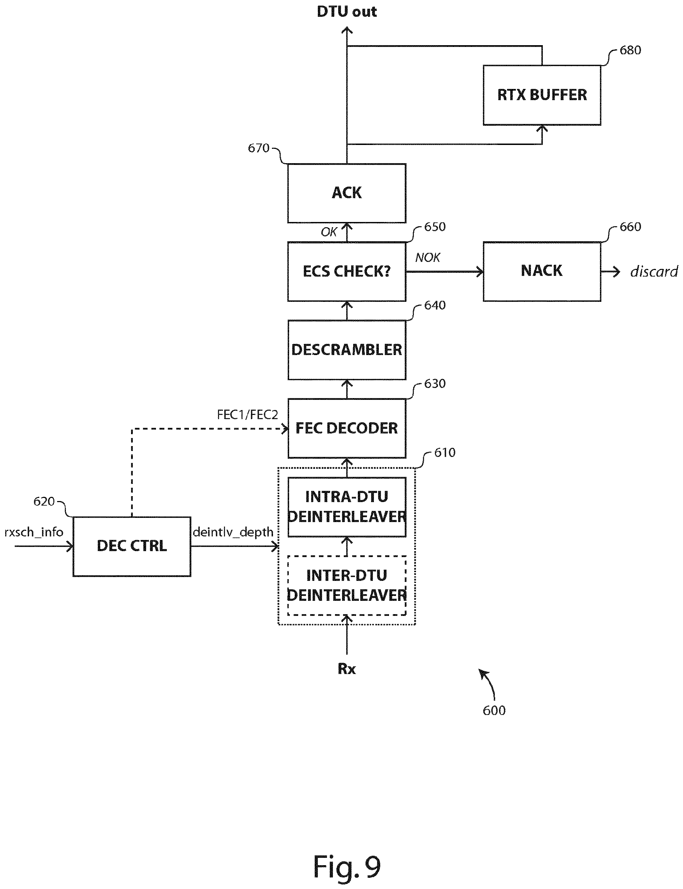

There is seen in fig. 9 an architecture 600 for a decoder as per the invention. The demodulated data are fed to a single block-deinterleaver 610 configured to perform the intra-DTU block-deinterleaving, possibly in conjunction with the inter-DTU block-deinterleaving. A decoder controller 620 (DEC CTRL) controls the deinterleaving depth deintlv_depth of the block-deinterleaver 610 based on receive scheduling information rxsch_info.

The receive scheduling information rxsch_info comprises an indication as to the type of data symbols over which the received DTUs have been conveyed. The receive scheduling info rxsch_info are either retrieved from the PMD layer, or are directly received from the remote transmitter based on the interleaving that has been applied at the transmit side. For the latter, the receive scheduling info rxsch_info may further comprise an indication as to whether the encoded DTUs have been block-interleaved in DTU-groups or not.

Based on the receive scheduling information rxsch_info, the decoder controller 620 adjusts the deinterleaving depth deintlv_depth to Q if the encoded DTUs have been sent individually without any further inter-DTU interleaving, or adjusts the deinterleaving depth deintlv_depth to M*Q if the encoded DTUs have been sent in DTU-groups with the further inter-DTU interleaving.

The properly de-interleaved DTUs are next fed to a FEC decoder 630 for error correction. Based on the receive scheduling information rxsch_info, the decoder controller 620 may further adjust the FEC settings to FEC1 or FEC2 depending on whether inter-DTU de-interleaving has been applied or not.

The information bytes are next sent to a de-scrambler 640 in order to recover the original DTUs.

The ECS is then checked by a block 650 in order to determine whether the received DTUs are correct. If the ECS of a particular DTU is incorrect, then a negative acknowledgment NACK is sent by a block 660 (NACK) to the transmitter for that particular DTU and the received DTU is discarded. If the ECS is correct, then a positive acknowledgment ACK is sent by a block 670 (ACK) for that particular DTU. If that DTU has as a sequence identifier that matches the next expected sequence identifier, then it is immediately delivered to the upper layer, else it is stored in a re-transmission buffer 680 (RTX BUFFER) awaiting for the correct receipt of the missing DTUs, or for the expiration of a re-transmission timer.

In order to save some communication bandwidth over the return acknowledgment channel, an entire DTU group can be acknowledged as a whole if none of its DTUs are erroneous.

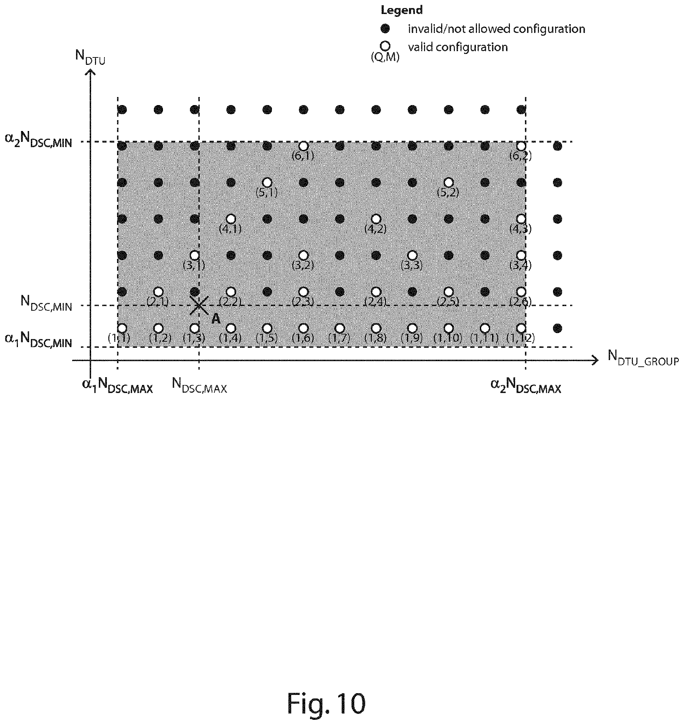

There is seen in fig. 10 a plot of the various operating points (Q,M) that can be used for performing the encoding as per the present invention.

On the horizontal axis, the size of a DTU-group $N_{DTU\_GROUP}$ is plotted (M*Q*$N_{FEC}$), while on the vertical axis the size of an encoded DTU $N_{DTU}$ is plotted (Q*NFEC). Also, the lower and upper bounds for the sizes of the DTU-groups and the encoded DTUs have been indicated as vertical and horizontal dashed lines respectively. The gray rectangle delimited by the dashed lines represents the set of valid operating points as they do obey the constraints of eq. (2) and (3). The invalid (Q,M) combinations have been plotted as black circles, whereas the valid ones with white circles. The corresponding (Q,M) values are indicated below the respective valid operating points.

The M and Q values can be chosen based on one or more of the following selection criterion:

- Select operating point 'closest' to $(N_{DSC,MIN}, N_{DSC,MAX})$ (e.g., in Euclidian distance) to have good granularity for retransmissions (see point 'A' in fig. 10).
- Select $Q=ceil (N_{DSC,MIN}/N_{FEC})$ to minimize DTU overhead.

Note that one could also extend fig. 10 with the additional dimension of $N_{FEC}$, and make a plot for each $N_{FEC}$ value. Selecting the operating point should then be done also across this dimension.

Although the above detailed description has focused primarily on wireline FDX communications over a copper plant, the present invention is similarly applicable to other communication technologies wherein multi-rates sub-frame structures have been defined in one or both directions of communication, and irrespective of the transmission medium being used (wireless transmission, mobile transmission, etc).

**List of Abbreviations**

ADC:        Analog to Digital Converter
AFE:        Analog Front-End
CRC:        Cyclic Redundancy Check
CPE:        Customer Premises Equipment
DAC:        Digital to Analog Converter
DMT:        Discrete Multi-Tone
DPU:        Distribution Point Unit
DS:         DownStream
DSC:        Data Symbol Capacity
DSL:        Digital Subscriber Line
DSLAM:      Digital Subscriber Line Access Multiplexer
DTA:        Dynamic Time Assignment
DTU:        Data Transfer Unit
ECS:        Error Check Sequence
EM:         Electro-Magnetic
FEC:        Forward-Error Correction
FDX:        Full-DupleX
FDS:        Full-duplex Downstream Sub-frame
FEXT:       Far-End crosstalk
FTTN:       Fiber To The Node
FUS:        Full-duplex Upstream Sub-frame
NEXT:       Near-End crosstalk
RS:         Reed-Solomon
RTX:        Re-Transmission
Rx:         Receiver
SLA:        Service Level Agreement
SNR:        Signal to Noise Ratio
TDD:        Time Division Duplexing
Tx:         Transmitter
UTP:        Unshielded Twisted Pair
US:         UpStream

**Claims**

1. **A method** for encoding **Data Transfer Units DTUs** (30) in **a transmitter** (111; 211) for further transmission to **a receiver** (212; 112),
communications from the transmitter to the receiver alternating between **first time sub-frames** (22; 24) comprising data symbols of **a first type** (D2; U2) having **a first data payload capacity** ($N_{DSC,MIN}$), and **second time sub-frames** (21; 23) comprising data symbols of **a second type** (D1; U1) having **a second data payload capacity** ($N_{DSC,MAX}$) greater than the first data payload capacity, the method comprising encoding individual DTUs into **Q block-interleaved codewords** (40) for protection against communication errors, Q denoting a positive integer value, *wherein* the method further comprises obtaining **scheduling information** (txsch_info) as to the types of data symbols over which the encoded DTUs (50) are to be conveyed; and enabling or disabling the further block-interleaving of **a group of M consecutive encoded DTUs** (60) based on the scheduling information for the respective M consecutive encoded DTUs, M denoting a positive integer value greater than one.

2. **A method** according to claim 1, *wherein* the method further comprises block-interleaving the group of M consecutive encoded DTUs and transmitting the block-interleaved group of M consecutive encoded DTUs (70) to the receiver if the M consecutive encoded DTUs are to be conveyed in whole over one or more contiguous data symbols of the second type.

3. **A method** according to claim 2, *wherein* the method further comprises individually transmitting one or more consecutive encoded DTUs from the group of M consecutive encoded DTUs to the receiver without any further interleaving if the M consecutive encoded DTUs are to be conveyed in part over one or more data symbols of the second type and in part over one or more data symbols of the first type, or if the M consecutive encoded DTUs are to be conveyed in whole over one or more data symbols of the first type.

4. **A method** according to claim 2, *wherein* the method further comprises block-interleaving the group of M consecutive encoded DTUs and transmitting the block-interleaved group of M consecutive encoded DTUs to the receiver if the M consecutive encoded DTUs are to be conveyed in part over one or more data symbols of the second type and in part over at most **a given number** of data symbols of the first type, the one or more data symbols of the second type and the at most given number of data symbols of the first type being contiguous data symbols.

5. **A method** according to claim 4, *wherein* the method further comprises individually transmitting one or more consecutive encoded DTUs from the group of M consecutive encoded DTUs to the receiver without any further interleaving if the M consecutive encoded DTUs are to be conveyed in part over one or more data symbols of the second type and in part over more than the given number of data symbols of the first type, or if the M consecutive encoded DTUs are to be conveyed in whole over one or more data symbols of the first type.

6. **A method** according to any one of claims 2 to 5, the first or second time sub-frames further comprising data symbols of **a third type** (RMC) conveying control traffic from the transmitter to the receiver and having **a third reduced data payload capacity** ($N_{RMC,DTU}$), *wherein* for enabling or disabling the further block-interleaving of the group of M consecutive encoded DTUs, data symbols of the third type are regarded as data symbols of the first or second type.

7. **A method** according to claim 1, *wherein* the DTUs are individually encoded into Q block-interleaved codewords according to **a first error code** (FEC1) if the encoded DTUs are to be individually transmitted to the receiver without any further interleaving, and according to **a second error code** (FEC2) if the encoded DTUs are to form part of a block-interleaved group of M consecutive encoded DTUs, the error encoding being controlled based on the scheduling information for the respective encoded DTUs.

8. **A method** according to claim 1, *wherein* **a size $N_{DTU}$** of the encoded DTUs is equal to $Q.N_{FEC}$, $N_{FEC}$ denoting the codeword length, the integers Q and M being determined so as to satisfy the following two inequalities:

$$\alpha_1 \cdot N_{DPC,MIN} \leq N_{DTU} \leq \alpha_2 \cdot N_{DPC,MIN} \text{ and } \alpha_1 \cdot \frac{N_{DPC,MAX}}{M} \leq N_{DTU} \leq \alpha_2 \cdot \frac{N_{DPC,MAX}}{M} \text{ , } N_{DPC,MIN} \text{ and}$$

$N_{DPC,MAX}$ denoting the first and second data payload capacities respectively, $\alpha_1$ and $\alpha_2$ denoting **a lower-bound proportion** ($\alpha 1$) and **an upper-bound proportion** ($\alpha 2$) of the data payload capacities.

9. **A method** according to claim 1, *wherein* the DTUs are the basic units for data re-transmission, and individually comprise **a header part** (HEADER), **a payload part** (PAYLOAD), and **an error check part** (ECS).

10. **A method** according to claim 1, *wherein* communications between the transmitter and the receiver are full-duplex communications, in downstream direction, the first time sub-frames corresponding to **upstream-priority sub-frames** (FUS) and the second time sub-frames corresponding to **downstream-priority sub-frames** (FDS), and in upstream direction, the first time sub-frames corresponding to **downstream-priority sub-frames** (FDS) and the second time sub-frames corresponding to **upstream-priority sub-frames** (FUS).

11. **A transmitter** (111; 211) comprising **an encoder** (305) configured to encode **Data Transfer Units DTUs** (30), and **an analog front-end** (360) configured to transmit **a communication signal** to **a receiver** (212; 112), the communication signal being generated based on the encoding,

communications from the transmitter to the receiver alternating between **first time sub-frames** (22; 24) comprising data symbols of **a first type** (D2; U2) having **a first data payload capacity,** ($N_{DSC,MIN}$) and **second time sub-frames** (21; 23) comprising data symbols of **a second type** (D1; U1) having **a second data payload capacity** ($N_{DSC,MAX}$) greater than the first data payload capacity, the encoder being further configured to encode individual DTUs into **Q block-interleaved codewords** (40) for protection against communication errors, Q denoting a positive integer value, *wherein* the encoder is further configured to obtain **scheduling information** (txsch_info) as to the types of data symbols over which the encoded DTUs (50) are to be conveyed; and to enable or disable the further block-interleaving of **a group of M consecutive encoded DTUs** (60) based on the scheduling information for the respective M consecutive encoded DTUs, M denoting a positive integer value greater than one.

12. **A transmitter** (111; 211) according to claim 11, the encoder comprising **a block-interleaver** (560) configured to block-interleave the Q codewords and the group of M consecutive encoded DTUs, *wherein* the block-interleaver has **an adjustable interleaving depth value** (intlv_depth) adjusted to Q*M if the further block-interleaving of the group of M consecutive encoded DTUs is enabled, else to Q.

13. **A transmitter** (111; 211) according to claim 11 or 12, *wherein* the transmitter further comprises at least one processor and at least one memory including computer program code, the at least one memory and the computer program code configured to, with the at least one processor, cause the transmitter to perform the encoding.

14. **A receiver** (112; 212) comprising **an analog front-end** (360) configured to receive **a communication signal** from **a transmitter** (211; 111), and **a decoder** (350) configured to decode **encoded Data Transfer Units DTUs** (30) from the communication signal,

communications from the transmitter to the receiver alternating between **first time sub-frames** (22; 24) comprising data symbols of **a first type** (D2; U2) having **a first data payload capacity,** ($N_{DSC,MIN}$) and **second time sub-frames** (21; 23) comprising data symbols of **a second type** (D1; U1) having **a second data payload capacity** ($N_{DSC,MAX}$) greater than the first data payload capacity, the encoded DTUs (50) individually comprising **Q block-interleaved codewords** (40) for protection against communication errors, Q denoting a positive integer value, *wherein* the decoder is further configured to obtain **scheduling information** (rxsch_info) as to the types of data symbols over which the encoded DTUs have been conveyed; and to enable or disable the block-deinterleaving of **a block-interleaved group of M consecutive encoded DTUs** (70) based on the scheduling information for the respective M consecutive encoded DTUs, M denoting a positive integer value greater than one.

15. **A receiver** (112; 212) according to claim 14, the decoder comprising **a block-deinterleaver** (610) configured to block-deinterleave the Q block-interleaved codewords and the block-interleaved group of M consecutive encoded DTUs, *wherein* the block-deinterleaver has **an adjustable deinterleaving depth value** (deintlv_depth) adjusted to Q*M if the block-deinterleaving of the block-interleaved group of M consecutive encoded DTUs is enabled, else to Q.

16. **A receiver** (112; 212) according to claim 14 or 15, *wherein* the scheduling information are obtained from the transmitter.

17. **A receiver** (112; 212) according to any one of claims 14 to 16, *wherein* the receiver further comprises at least one processor and at least one memory including computer program code, the at least one memory and the computer program code configured to, with the at least one processor, cause the receiver to perform the decoding.

18. **A network equipment** (100; 200) comprising **a transmitter** according to any one of claims 11 to 13, and/or **a receiver** (112; 212) according to any one of claims 14 to 17.

Fig. 1

Fig. 2A

Fig. 2B

FDX Frame = $N_F x T_S$

| DS Tx | D1 | D1 | D1 | D1 | D1 | D1 | D1 | D1 | | D2 | D2 | D2 | D2 |

$T_S$

| US Tx | U2 | U2 | U2 | U2 | U2 | U2 | U2 | U2 | | U1 | U1 | U1 | U1 |

$T_g$

FDS sub-frame = $N_{FDS} \times T_S$

FUS sub-frame = $N_{FUS} \times T_S$

# Fig. 3

DTU

$Q \times K_{FEC}$

| HEADER | | PAYLOAD | | ECS |

$N_{FEC} = K_{FEC} + R_{FEC}$

$K_{FEC}$  $R_{FEC}$

RS Codeword 1   $40_1$

$N_{FEC}$

$K_{FEC}$  $R_{FEC}$

RS Codeword Q   $40_Q$

$Q \times N_{FEC}$

Fig. 4A

RS Codeword 1

RS Codeword 2

RS Codeword Q

INTRA DTU
BLOCK-INTERLEAVING

Write Order (Tx)

Read Order (Tx)

Fig. 4B

Encoded DTU

50

$Q \times N_{FEC}$

Fig. 4C

Fig. 5A

Interleaved Group of M Encoded DTUs

Fig. 5B

Fig.6A

Fig.6B

DTU in

↓

SCRAMBLER ⌐410

↓

FEC ENCODER ⌐420

↓

INTRA-DTU
INTERLEAVER ⌐430

↓

ENCODED DTU
BUFFER ⌐440

RTX BUFFER ⌐450

RTX MUX

460

txsch_info → ENC CTRL  —enable→  INTER-DTU
INTERLEAVER

480 470

↓

Tx

400

# Fig. 7

Fig. 8

DTU out

RTX BUFFER — 680

670 — ACK

ECS CHECK? — 650

NACK — 660 → *discard*

*OK* / *NOK*

DESCRAMBLER — 640

FEC DECODER — 630

FEC1/FEC2

INTRA-DTU DEINTERLEAVER — 610

INTER-DTU DEINTERLEAVER

DEC CTRL — 620

rxsch_info

deintlv_depth

Rx

600

Fig. 9

Fig. 10

Europäisches
Patentamt
European
Patent Office
Office européen
des brevets

**EUROPEAN SEARCH REPORT**

Application Number

EP 18 17 7773

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DANNY VAN BRUYSSEL NOKIA FINLAND: "G.mgfast: Framing proposal for mgfast;C19", ITU-T DRAFT; STUDY PERIOD 2017-2020; STUDY GROUP 15; SERIES C19, INTERNATIONAL TELECOMMUNICATION UNION, GENEVA ; CH , vol. 4/15 21 November 2017 (2017-11-21), pages 1-5, XP044213233, Retrieved from the Internet: URL:https://www.itu.int/ifa/t/2017/sg15/docs/rgm/Q4-171127/C/T17-SG15RGM-Q4-171127-C-0019.docx [retrieved on 2017-11-21] * sections 2 and 3 * ----- | 1-18 | INV. H04L1/00 H03M13/27 H04L5/00 |
| A | INFINEON ET AL: "G.INP: Text proposal for the retransmission scheme in G.INP;TD09GS-076", ITU-T DRAFT ; STUDY PERIOD 2009-2012, INTERNATIONAL TELECOMMUNICATION UNION, GENEVA ; CH, vol. 4/15, 6 May 2009 (2009-05-06), pages 1-37, XP044154661, [retrieved on 2009-05-06] * section 9.2 * ----- | 1-18 | |
| A | US 2006/150059 A1 (MODLIN CORY S [US]) 6 July 2006 (2006-07-06) * abstract; figure 2 * * paragraph [0018] - paragraph [0024] * ----- | 1-18 | TECHNICAL FIELDS SEARCHED (IPC) H04L H03M |

-/--

The present search report has been drawn up for all claims

| Place of search | Date of completion of the search | Examiner |
|---|---|---|
| Munich | 7 December 2018 | Martínez Martínez, V |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

**EUROPEAN SEARCH REPORT**

Application Number

EP 18 17 7773

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | DANNY VAN BRUYSSEL NOKIA FINLAND: "G.mgfast: DTU grouping for G.mgfast;C36", ITU-T DRAFT; STUDY PERIOD 2017-2020; STUDY GROUP 15; SERIES C36, INTERNATIONAL TELECOMMUNICATION UNION, GENEVA ; CH , vol. 4/15 19 June 2018 (2018-06-19), pages 1-8, XP044246381, Retrieved from the Internet: URL:https://www.itu.int/ifa/ifa/t/2017/sg15/docs/rgm/Q4-180625/C/T17-SG15RGM-Q4-180625-C-0036.docx [retrieved on 2018-06-19] * the whole document * ----- | | |

TECHNICAL FIELDS SEARCHED (IPC)

The present search report has been drawn up for all claims

| Place of search | Date of completion of the search | Examiner |
|---|---|---|
| Munich | 7 December 2018 | Martínez Martínez, V |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 17 7773

This annex lists the patent family members relating to the patent documents cited in the above-mentioned European search report.
The members are as contained in the European Patent Office EDP file on
The European Patent Office is in no way liable for these particulars which are merely given for the purpose of information.

07-12-2018

| Patent document cited in search report | Publication date | Patent family member(s) | Publication date |
|---|---|---|---|
| US 2006150059 A1 | 06-07-2006 | NONE | |

For more details about this annex : see Official Journal of the European Patent Office, No. 12/82

EPO FORM P0459